# FASCICULE DE BREVET EUROPEEN

(11) **EP 0 828 261 B1**
(45) Date de publication et mention de la délivrance du brevet: **28.11.2001**
(21) Numéro de dépôt: 97402042.2
(22) Date de dépôt: 02.09.1997
(51) Int. Cl.: H01C 10/32, H01C 17/065

(54) **Procédé de réalisation d'un circuit de réglage asservi de la position d'un organe mobile notamment dans un correcteur de l'orientation du faisceau d'un projecteur de véhicule automobile, et circuit de réglage selon le procédé**
Verfahren zur Herstellung eines Steuerkreislaufs für die Positionierung eines beweglichen Organs, insbesondere zur Verwendung in einer Steuerungseinrichtung zur Neigung eines Fahrzeugscheinwerfers
Method of manufacturing a control circuit for positioning a mobile element, in particular used in a device controlling the inclination of a vehicle headlamp

(30) Priorité: 03.09.1996 FR 9610715
(43) Date de publication de la demande: 11.03.1998
(73) Titulaire: VALEO VISION, 93000 Bobigny (FR)
(72) Inventeur: Metayer, Guy, 92150 Suresnes (FR); Bazard, Sébastien, 75010 Paris (FR)
(74) Mandataire: Le Forestier, Eric

(56) Documents cités:
- EP-A- 0 466 539
- EP-A- 0 509 420
- US-A- 4 139 831
- US-A- 5 051 719
- "Silk-screening prints conductors, resistors on circuit boards" ELECTRONICS, vol. 47, no. 15, 25 juin 1974, pages 33-34, XP002031025

## Description

La présente invention a trait d'une façon générale aux dispositifs de réglage asservi de la position d'un organe mobile. En particulier, elle concerne un procédé de fabrication du circuit électrique d'un dispositif de réglage de l'orientation du faisceau lumineux émis par un projecteur de véhicule automobile.

De façon classique, un tel dispositif est logé dans le projecteur et comporte une tige de commande mobile en rotation et/ou en translation, commandée par un moto-réducteur et agissant sur un point de réglage du miroir du projecteur.

Un circuit électronique associé reçoit un signal de consigne désignant une position angulaire, choisie parmi un ensemble de positions discrètes, dans laquelle doit être amenée la tige.

L'information indiquant d'une part quelle est la position courante, et d'autre part si la position demandée a bien été atteinte, est obtenue à l'aide d'un curseur mobile avec la tige de commande et se déplaçant le long d'une piste divisée en plusieurs zones.

Un circuit intégré spécifique est associé à ce mécanisme à curseur de manière à effectuer la commande asservie de position.

De façon classique, le curseur se déplace sur deux pistes, à savoir sur une première piste subdivisée en plusieurs zones adjacentes, portées à des potentiels différents et dont certaines au moins définissent des positions d'arrêt du curseur et donc de l'organe mobile, et une seconde piste continue, en contact essentiellement non résistif avec le curseur, pour recueillir le potentiel prélevé sur l'autre piste.

Au moins cette seconde piste est constituée par une zone métallisée qui a été revêtue de nickel ou d'or afin d'une part d'éviter les phénomènes d'oxydation liés au contact cuivre-cuivre, et d'autre part d'accroître sa résistance à l'abrasion.

L'inconvénient majeur d'un tel dispositif est qu'avec les techniques usuelles de gravure chimique des différentes zones conductrices, il existe sur le trajet du curseur des zones hors-tension plus ou moins étendues, pour lesquelles celui-ci n'est plus à même d'informer le circuit de commande de sa position courante. En outre, les positions d'arrêt du curseur peuvent, avec cette technique, être fixées d'une manière insuffisamment précise, et incompatible avec la précision requise par la règlementation en matière d'inclinaison en zite d'un faisceau de projecteur (notamment d'un faisceau de croisement).

Un autre inconvénient de ce dispositif connu est qu'il est coûteux, d'une part par la nécessité de traiter au moins l'une des pistes du curseur à l'or ou au nickel, et d'autre part par la nécessité de recourir à un circuit intégré spécifique pour détecter avec suffisamment de fiabilité la position du curseur et effectuer la commande appropriée du moteur.

La présente invention a pour premier objet de réduire sensiblement les zones dans lesquelles le curseur ne recueille aucune tension, et de définir avec davantage de précision les positions des différents points d'arrêt du curseur.

Elle a également pour objet, en ayant recours à des moyens communs, de réaliser des résistances discrètes de précision permettant de recourir, pour effectuer la commande asservie du moteur, à des composants du commerce peu coûteux.

Elle a aussi pour objet, en ayant recours ici encore à des moyens communs, de réaliser de façon beaucoup plus économique une couche résistant à l'abrasion.

Un autre objet encore de la présente invention est de rendre les modifications du circuit extrêmement aisées et peu coûteuses.

Ainsi la présente invention propose un procédé de réalisation d'une partie d'un circuit électrique d'un dispositif de réglage de la position d'un organe mobile, notamment pour corriger l'orientation d'un faisceau de projecteur de véhicule automobile, ladite partie de circuit comprenant un curseur solidaire en déplacement avec l'organe mobile et une piste sur laquelle le curseur est apte à se déplacer avec contact électrique, ladite piste comportant une pluralité de zones adjacentes mais isolées les unes des autres et amenées à des potentiels différents, dont au moins certaines définissent des positions d'arrêt du curseur et de l'organe mobile, caractérisé en ce qu'il comprend les étapes consistant à :
(a) déposer par sérigraphie sur un substrat un matériau résistif constituant ladite piste, et
(b) séparer la piste en les différentes zones par découpage au Laser.

Des aspects préférés, mais non limitatifs, du procédé selon l'invention sont les suivants :
- lorsque ladite partie de circuit comprend en outre une seconde piste s'étendant le long de la première et destinée à établir un contact sensiblement non résistif avec le curseur, alors ladite seconde piste comprend une zone métallique continue et au cours de l'étape (a), on dépose également de la peinture électriquement conductrice sur ladite zone métallique, de manière à réaliser une surface essentiellement non-résistive résistant à l'abrasion.
- lorsque ladite partie de circuit comprend en outre une série de résistances électriques discrètes formant pont diviseur pour fixer les potentiels présents sur lesdites zones de la première piste, alors ladite peinture est une peinture résistive, et l'on forme sur le substrat, au cours de l'étape (a), des zones de peinture définissant lesdites résistances discrètes, et l'on découpe au Laser dans lesdites zones, au cours de l'étape (b), des entailles d'ajustement de la valeur ohmique desdites résistances discrètes.
- lorsque ladite partie de circuit comprend en outre une série de résistances électriques discrètes formant ponts diviseurs pour fixer des tensions de seuil à des fins de comparaison avec la tension recueillie par le curseur, alors ladite peinture est une peinture résistive, et l'on forme sur le substrat, au cours de l'étape (a), des zones de peinture définissant lesdites résistances discrètes, et l'on découpe au Laser dans lesdites zones, au cours de l'étape (b), des entailles d'ajustement de la valeur ohmique desdites résistances discrètes.
- ladite peinture est une peinture au carbone.

D'autres aspects, buts et avantages de la présente invention apparaîtront mieux à la lecture de la description détaillée suivante d'une forme de réalisation préférée de celle-ci, donnée à titre d'exemple et faite en référence au dessin annexé, sur lequel :
la figure 1 illustre un circuit imprimé d'un dispositif de réglage fabriqué selon l'invention, et
la figure 2 illustre une partie du schéma du circuit électrique réalisé à l'aide du circuit imprimé de la figure 1.

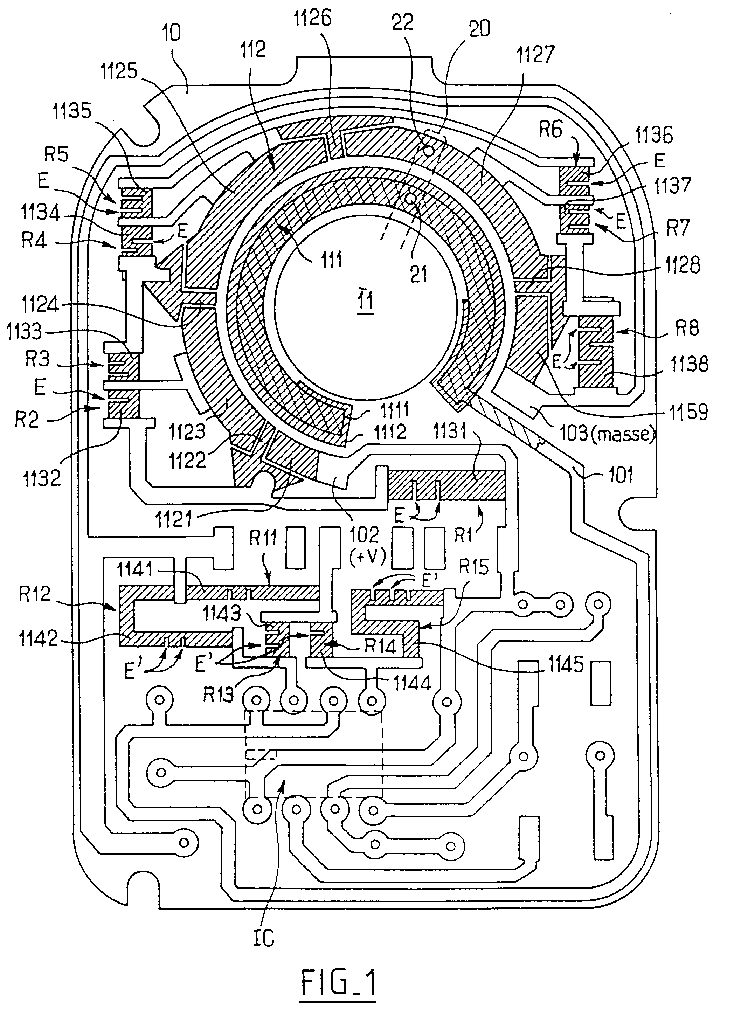

En référence maintenant à la figure 1, on a représenté un circuit imprimé destiné à être logé dans le boîtier (non représenté) d'un dispositif correcteur de l'orientation du faisceau d'un projecteur de véhicule automobile, le correcteur étant du type à positions discrètes.

De façon classique en soi, le circuit imprimé comporte un substrat isolant 10 dans lequel est pratiquée une ouverture circulaire 11 traversée en son centre par la tige de sortie rotative (non représentée) du correcteur, entraînée par un moteur électrique, associé à un réducteur (également non représentés).

Sur cette tige est monté, solidaire en rotation avec elle, un curseur radial 20 comportant deux plots de contact 21 et 22.

Sur le circuit imprimé est formé un motif de pistes conductrices, réalisées conventionnellement par gravure de cuivre. L'on ne décrira pas en détail le tracé précis de ces pistes, l'homme du métier étant à même de concevoir le motif approprié en fonction de la répartition des composants.

Le circuit électrique monté sur ce circuit imprimé comprend, de façon classique en soi, une partie de lecture de la position angulaire du curseur 20 et donc de la tige de sortie du correcteur, et une partie de commnde du moteur d'entraînement de la tige.

De façon également classique, le curseur se déplace sur une piste annulaire intérieure, désignée par la référence 111, et sur une piste annulaire extérieure 112, coaxiale avec la piste 111. Les pistes 111 et 112 ont une étendue angulaire inférieure à 360°, et typiquement de l'ordre de 300° à 330°.

La piste intérieure 111 est reliée par une piste conductrice 101 au circuit de commande, en fournissant à ce dernier un signal de lecture de la position angulaire du curseur.

La piste extérieure 112 est subdivisée en plusieurs zones électriquement isolées les unes des autres et placées à des potentiels prédéterminés, de manière à ce que la valeur de la tension du signal de mesure soit représentatif de la position angulaire du curseur.

Dans le cas d'espèce, la piste extérieure comporte une pluralité de zones de faible largeur, respectivement 1122, 1124, 1126, 1128, définissant précisément quatre positions d'arrêt discrètes du curseur 20 et donc de la tige de correcteur. De part et d'autre de ces zones d'arrêt s'étendent des zones de déplacement 1121, 1123, 1125, 1127 et 1129. Les zones 1121 à 1129 s'étendent en séquence entre deux plots de conducteurs 102, 103.

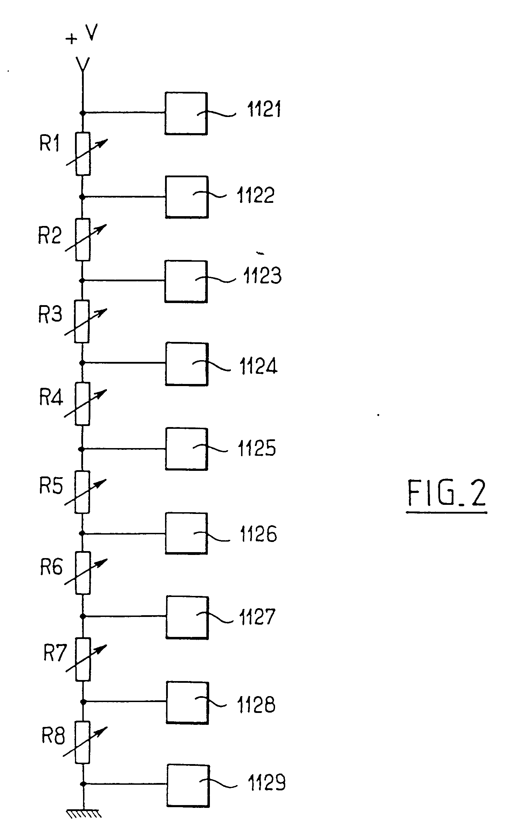

Par ailleurs, un pont diviseur constitué par huit résistances discrètes R1 à R8 est branché entre une source de tension positive +V et la masse, de manière à appliquer aux neuf zones 1121 à 1129 neuf potentiels différents régulièrement répartis entre +V et zéro volt (masse). Le schéma électrique de ce pont diviseur est représenté sur la figure 2.

Selon un aspect essentiel de l'invention, les différentes zones de la piste extérieure 112 ainsi que les résistances R1 à R8 sont réalisées par dépôt d'une peinture au carbone, par une technique de sérigraphie.

Ainsi les résistances R1 à R8 sont constituées par des zones de dépôt de peinture au carbone désignées par les références 1131 à 1138, de forme généralement rectangulaire, qui sont reliées entre elles par des pistes de cuivre 1002 à 1008, et à la tension +V et à la masse par des pistes de cuivre 1001 et 1009.

Selon un autre aspect de l'invention, la piste annulaire extérieure 112 est réalisée par un dépôt continu de peinture au carbone, et l'on utilise un découpage au rayon Laser pour créer ensuite les différentes zones.

On comprend que la précision de tracé inhérente à cette technologie permet de définir un positionnement extrêmement précis des zones d'arrêt 1122, 1124, 1126 et 1128.

Avantageusement, on utilise également cette technique de découpage au Laser pour former dans les différentes résistances 1131 à 1138 des entailles transversales, désignées par la référence E, destinées à fixer d'une manière extrêmement précise la valeur ohmique de chacune de celles-ci.

Grâce à cet aspect de l'invention, les potentiels sur les différentes zones de la piste extérieure 112 sur laquelle se déplace le curseur peuvent être ajustés d'une façon extrêmement précise, et en même temps d'une façon tout à fait économique. En outre, toute modification souhaitée de la valeur ohmique des résistances peut être effectuée par simple programmation du trajet de l'outil de découpage au Laser.

On observera ici que la résistance électrique de surface des différentes zones 1121 à 1129 de la piste extérieure 112 s'avèrera non perturbante si la couche est relativement épaisse, et si les circuits qu'attaque le signal prélevé sur le curseur présentent une impédance d'entrée suffisamment élevée.

On observera ici que la largeur des séparations entre les différentes zones 1121 à 1129 de la piste 112 ainsi que la largeur des entailles E formées dans les résistances a été exagérée sur le dessin par souci de clarté. Dans la pratique, cette largeur est de quelques dizaines de microns.

Selon un autre aspect de la présente invention, la piste intérieure 111 du curseur est avantageusement constituée d'une piste de cuivre 1111 recouverte d'une couche 1112 de la même peinture au carbone que celle utilisée pour la piste extérieure 112 et pour les résistances R1 à R8. Ceci permet d'obtenir une piste qui présente une excellente résistance à l'abrasion, tout en étant beaucoup moins coûteuse que les pistes conventionnellement traitées pour résister à l'abrasion à l'aide d'un revêtement de nickel ou d'or. En outre, la résistance électrique de contact induite par l'utilisation d'une peinture au carbone comme couche de frottement ne provoque, ici encore, pas de perturbation gênante dans le signal de mesure dans le cas où celui-ci attaque un étage comparateur à haute impédance du circuit de commande.

Selon un autre aspect intéressant de la présente invention, le circuit de commande est constitué par un circuit comparateur du commerce auquel peuvent être appliquées différentes tensions de seuil, par l'intermédiaire d'un circuit de commutation à semiconducteur (référence IC), également du commerce, l'ensemble étant utilisé en lieu et place d'un circuit intégré spécifique utilisé fréquemment dans ce genre de correcteur.

De tels circuits du commerce peuvent être utilisés dans la mesure où ils sont associés à un pont diviseur résistif dont les valeurs ohmiques des résistances discrètes sont suffisamment précises.

Ainsi il est particulièrement avantageux de réaliser les cinq résistances R11 à R15 constituant ce pont diviseur selon la même technique que les résistances R1 à R8. Ainsi, dans le présent exemple, ces résistances sont constituées par cinq zones 1141 à 1145 de dépôt sérigraphié de peinture au carbone, et des entailles E' sont formées par découpage au Laser pour en ajuster précisément la valeur ohmique.

Ainsi, c'est la conjonction d'une grande précision dans les potentiels présents sur les différentes zones de la piste extérieure 112 du curseur, et d'une grande précision dans les potentiels appliqués au comparateur du circuit de commande, qui permet d'utiliser un circuit comparateur du commerce, peu coûteux.

En conclusion, la présente invention permet de réaliser d'une façon extrêmement simple et économique un circuit électrique de commande asservie d'un dispositif de réglage à positions discrètes, tel qu'un correcteur d'orientation de faisceau d'un projecteur de véhicule automobile, et permet d'utiliser pour un tel dispositif des composants actifs du commerce.

Bien entendu, la présente invention n'est nullement limitée à la forme de réalisation décrite ci-dessus et représentée sur les dessins.

En particulier, bien que l'on ait décrit ci-dessus un circuit applicable à un correcteur à sortie rotative, l'homme du métier saura faire les adaptation nécessaires pour un correcteur à sortie linéaire.

## Revendications

1. Procédé de réalisation d'une partie d'un circuit électrique d'un dispositif de réglage de la position d'un organe mobile, notamment pour corriger l'orientation d'un faisceau de projecteur de véhicule automobile, ladite partie de circuit comprenant un curseur (20) solidaire en déplacement avec l'organe mobile et une piste (112) sur laquelle le curseur est apte à se déplacer avec contact électrique, ladite piste comportant une pluralité de zones adjacentes (1121-1129) mais isolées les unes des autres et amenées à des potentiels différents, dont au moins certaines (1122, 1124, 1126, 1128) définissent des positions d'arrêt du curseur et de l'organe mobile, **caractérisé en ce qu'**il comprend les étapes consistant à :
(a) déposer par sérigraphie sur un substrat un matériau résistif constituant ladite piste, et
(b) séparer la piste en les différentes zones par découpage au Laser.

2. Procédé selon la revendication 1, ladite partie de circuit comprenant en outre une seconde piste (111) s'étendant le long de la première et destinée à établir un contact sensiblement non résistif avec le curseur (20), **caractérisé en ce que** ladite seconde piste comprend une zone métallique continue (1111) et **en ce qu'**au cours de l'étape (a), on dépose également de la peinture électriquement conductrice (1112) sur ladite zone métallique, de manière à réaliser une surface essentiellement non-résistive résistant à l'abrasion.

3. Procédé selon l'une des revendications 1 et 2, ladite partie de circuit comprenant en outre une série de résistances électriques discrètes (R1-R8) formant pont diviseur pour fixer les potentiels présents sur lesdites zones (1121-1129) de la première piste (112), **caractérisé en ce qu'**au cours de l'étape (a), on forme sur le substrat des zones de matériau résistif (1131-1138) définissant lesdites résistances discrètes, et **en ce qu'**au cours de l'étape (b), on découpe au Laser dans lesdites zones des entailles (E) d'ajustement de la valeur ohmique desdites résistances discrètes.

4. Procédé selon l'une des revendications 1 à 3, ladite partie de circuit comprenant en outre une série de résistances électriques discrètes (R11-R15) formant ponts diviseurs pour fixer des tensions de seuil à des fins de comparaison avec la tension recueillie par le curseur, **caractérisé en ce qu'**au cours de l'étape (a), on forme sur le substrat des zones de matériau résistif (1141-1145) définissant lesdites résistances discrètes, et **en ce qu'**au cours de l'étape (b), on découpe au Laser dans lesdites zones des entailles (E') d'ajustement de la valeur ohmique desdites résistances discrètes.

5. Procédé selon l'une des revendications 1 à 4, **caractérisé en ce que** le matériau résistif est une peinture au carbone.

## Patentansprüche

1. Verfahren zur Herstellung eines Teils einer elektrischen Schaltung für eine Vorrichtung zur Regelung der Position eines beweglichen Elements, insbesondere zur Regelung der Ausrichtung eines Lichtbündels eines Kraftfahrzeugscheinwerfers, wobei dieser Teil der Schaltung einen mit dem beweglichen Element bei Bewegung fest verbundenen Abgreifer (20) sowie eine Bahn (112) aufweist, auf der sich der Abgreifer mit elektrischem Kontakt bewegen kann, wobei diese Bahn eine Vielzahl von angrenzenden, jedoch voneinander isolierten Bereichen (1121-1129) mit unterschiedlichen elektrischen Potentialen umfaßt, von denen zumindest einige (1122, 1124, 1126, 1128) Haltepositionen des Abgreifers und des beweglichen Elements bilden,
**dadurch gekennzeichnet, daß** das Verfahren die Schritte umfaßt, die bestehen im:
(a) Aufbringen eines die genannte Bahn bildenden resistiven Materials auf ein Substrat im Siebdruckverfahren, und
(b) Trennen der Bahn in die verschiedenen Bereiche durch Laserschneiden.

2. Verfahren nach Anspruch 1, wobei der Teil der Schaltung ferner eine zweite Bahn (111) umfaßt, die entlang der ersten Bahn verläuft und zum Herstellen eines im wesentlichen nicht resistiven Kontakts mit dem Abgreifer (20) bestimmt ist,
**dadurch gekennzeichnet, daß** diese zweite Bahn einen durchgehenden Metallbereich (1111) aufweist und daß im Schritt (a) auch eine elektrisch leitende Farbe (1112) auf diesen Metallbereich aufgebracht wird, so daß eine im wesentlichen nicht resistive, abriebfeste Oberfläche hergestellt wird.

3. Verfahren nach einem der Ansprüche 1 oder 2, wobei der Teil der Schaltung ferner eine Reihe diskreter elektrischer Widerstände (R1-R8) aufweist, die eine Teilungsbrücke bilden, um die elektrischen Potentiale festzulegen, die auf den Bereichen (1121-1129) der ersten Bahn (112) vorhanden sind,
**dadurch gekennzeichnet, daß** im Schritt (a) Bereiche mit resistivem Material (1131-1138) auf dem Substrat ausgebildet werden, die diese diskreten Widerstände bilden, und daß im Schritt (b) in diesen Bereichen mit dem Laser Einschnitte (E) zur Anpassung des Ohmschen Wertes dieser diskreten Widerstände ausgeführt werden.

4. Verfahren nach einem der Ansprüche 1 bis 3, wobei dieser Teil der Schaltung ferner eine Reihe von diskreten elektrischen Widerständen (R11-R15) umfaßt, die Teilungsbrücken bilden, um Schwellenspannungen zum Abgleich mit der vom Abgreifer erfaßten Spannung festzulegen,
**dadurch gekennzeichnet, daß** im Schritt (a) Bereiche mit resistivem Material (1141-1145) auf dem Substrat ausgebildet werden, die diese diskreten Widerstände bilden, und daß im Schritt (b) in diesen Bereichen mit dem Laser Einschnitte (E') zur Anpassung des Ohmschen Wertes dieser diskreten Widerstände ausgeführt werden.

5. Verfahren nach einem der Ansprüche 1 bis 4,
**dadurch gekennzeichnet, daß** das resistive Material eine Kohlenstoffarbe ist.

## Claims

1. Method of producing a section of an electrical circuit belonging to a device for adjusting the position of a movable member, particularly for correcting the orientation of a motor vehicle headlight beam, said circuit section comprising a cursor (20) which is secured in motion to the movable member, and a track (112) along which the cursor is able to move in electrical contact, said track comprising a plurality of zones (1121-1129) which are adjacent but insulated from one another and raised to different potentials, at least certain ones (1122, 1124, 1126, 1128) of which define stop positions of the cursor and the movable member, **characterised in** it comprises the steps consisting of:
(a) depositing on a substrate by screen printing a resistive material forming said track, and
(b) separating the track into the different zones by cutting with a laser.

2. Method according to claim 1, said circuit section also comprising a second track (111) which extends along the first track and which is intended to make substantially non-resistive contact with the cursor (20), **characterised in that** said second track comprises a continuous metallic zone (1111) and **in that** in the course of step (a) electrically conductive paint (1112) is also deposited on said metallic zone, in such a way as to produce a substantially non-resistive abrasion-resistant surface.

3. Method according to either of claims 1 and 2, said circuit section also comprising a series of discrete electrical resistors (R1-R8) which form a divider bridge to set the potentials present at said zones (1121-1129) of the first track (112), **characterised in that** in the course of step (a) zones of resistive material (1131-1138) defining said discrete resistors are formed on the substrate, and **in that** in the course of step (b) cutouts (E) for adjusting the resistive value of said discrete resistors are cut in said zones by laser.

4. Method according to any of claims 1 to 3, said circuit section also comprising a series of discrete electrical resistors (R11-R15) which form divider bridges to set threshold voltages for the purposes of comparison with the voltage picked up by the cursor, **characterised in that** in the course of step (a) zones of resistive material (1141-1145) defining said discrete resistors are formed on the substrate, and **in that** in the course of step (b) cutouts (E') for adjusting the resistive value of said discrete resistors are cut in said zones by laser.

5. Method according to any of claims 1 to 4, **characterised in that** the resistive material is a paint containing carbon.
